# EUROPEAN PATENT APPLICATION

(11) **EP 4 379 327 A1**
(43) Date of publication of application: **05.06.2024**
(21) Application number: 23212456.0
(22) Date of filing: 27.11.2023
(51) Int. Cl.: G01F 15/14, G01F 15/00, G01F 15/06, B33Y 80/00, G01R 11/24, G01D 11/08, G01D 11/10, G01D 11/16, G01D 11/24

(54) **COVER ASSEMBLY FOR A UTILITY METER**

(30) Priority: 29.11.2022 DE 102022131648
(71) Applicant: Landis+Gyr GmbH, 90459 Nürnberg (DE)
(72) Inventor: OLBERS, Andreas, 90411 Nürnberg (DE)
(74) Representative: Marks & Clerk LLP

(57) **Abstract**

A cover assembly (12) for a utility meter (10) comprises a housing (16). The assembly (12) comprises a lid (18) that is detachably connectable to the housing (16). At least one of the housing (16) and the lid comprises a shaft (22). At least one other of the housing (16) and the lid (18) comprises a connector. When the lid is connected to the housing, the connector (24) is configured to connect to the shaft (22) and to apply a force on the shaft (22) that allows rotational movement of the lid relative to the housing and inhibits gravitational movement of the lid relative to the housing.

## Description

### FIELD

The present disclosure relates a cover assembly, a utility meter and associated methods.

### BACKGROUND

A utility meter may be used for measuring usage on a utility main. The utility meter may comprise a cover for protecting the utility meter from damage and/or dirt. Such a cover may comprise a hinged lid attached to a casing. The attachment of the lid to the casing may include the use of complicated latch and/or rigid guide arrangements. Known covers have either dispensed with hinged lids or used a cross-shaped hinge with snap hooks. In such covers, the hinge may include a number of pins that extend through respective eyelets. The pins may break, e.g. due to improper handling, resulting in a defective cover.

It may be desirable to hold the lid in a certain position relative to the casing to allow the meter to be read, e.g. when the meter is installed vertically or horizontally. In known covers, simple hinges were used, which did not inhibit movement of the lid. Alternatively, the cross-shaped hinge can been used, which can snap the lid in a position of 90° and 180° relative to the housing, e.g. using the snap hooks. However, such a hinge can cause unwanted noise and/or may be susceptible to material failure.

It is therefore an aim of at least one embodiment of at least one aspect of the present disclosure to obviate or at least mitigate at least one of the above identified shortcomings of the prior art.

### SUMMARY

According to a first aspect of the present disclosure, there is provided a cover assembly for a utility meter. The assembly comprises a housing. The assembly comprises a lid. The lid is detachably connectable to the housing. At least one of the housing and the lid comprises a shaft. At least one other of the housing and the lid comprises a connector. When the lid is connected to the housing, the connector is configured to connect to the shaft. When the lid is connected to the housing, the connector is configured to apply a force on the shaft that allows rotational movement of the lid relative to the housing and inhibits gravitational movement of the lid relative to the housing.

The force applied on the shaft may be considered as a compressive force. The force applied on the shaft may result in friction, e.g. increased friction, between the shaft and the connector, e.g. when the lid is rotated relative to the housing. Due to the friction between the shaft and the connector, gravitational movement of the lid relative to the housing may be inhibited. The shaft and the connector may be considered to be self-locking, e.g. due to the friction between the shaft and the connector.

By configuring the connector to apply a force on the shaft that allows rotational movement of the lid relative to the housing and inhibits gravitational movement of the lid relative to the housing, reading of the utility meter, which may be vertically or horizontally installed, may be facilitated. Additionally or alternatively, the use of additional fastenings, such as hooks, snap-hooks, clasps, clips or the like, to maintain the lid in an open or closed position may be avoided. A risk of damage to the connector and/or shaft may also be reduced.

The connector may be formed from a first material. The shaft may be formed from a second material. The first and second materials may be selected such that the connector applies the force on the shaft, e.g. when the lid is connected to the housing. The first material may comprise an elastic modulus that is different from an elastic modulus of the second material. For example, the first material may comprise an elastic modulus that is lower than an elastic modulus of the second material. This may result in the increased friction between the shaft and the connector. Additionally or alternatively, this may allow for noise and/or squeaking, e.g. when the lid is rotated relative to the housing, to be reduced or prevented.

The first material may comprise an elastomeric material or a thermoplastic elastomeric material. The second material may comprise a thermoplastic polymer material.

The housing may comprise a window for displaying a consumed value. For example, the consumed value may be visible through the window. The consumed valued may be understood as a value or amount of a utility, e.g. water, thermal energy, gas, electricity or the like, that has been used. For example, when the lid is connected to the housing, the lid may be rotatable between a closed position and an open position. In the closed position, the lid may at least partially cover a portion of the housing. For example, in the closed position, at least the window may be covered by the lid. In the open position, the portion of the housing may be uncovered. For example, in the open position, the window may be uncovered. The portion of the housing may comprise a window for inspecting the utility meter. The portion of the housing may also be referred to as an inspection portion. The lid and the housing may be configured such that, when the lid is in the open position, an angle between the lid and the housing is larger than 0° and smaller than about 280°.

For example, when the lid is connected to the housing, the connector may be configured to connect to one or more portions of the shaft. For example, when the lid is connected to the housing, the connector may be configured to apply the force on the one or more portions of the shaft. For example, when the lid is connected to the housing, the connector may be configured to form an interference fit or press fit with the one or more portions of the shaft. The one or more portions of the shaft may comprise a first end portion, a second end portion and/or a portion between the first and second end portions.

For example, when the lid is connected to housing, the connector may be configured to at least partially enclose the one or more portions of the shaft. The connector may be configured to enclose between about 70% and 80% of a circumference of the one or more portions of the shaft. By configuring the connector to enclose between about 70% and 80% of a circumference of the one or more portions of the shaft, the force applied on the one or more portions of the shaft may be sufficient to inhibit gravitational movement of the lid relative to the housing. Additionally or alternatively, by configuring the connector to enclose between about 70% and 80% of the circumference of the one or more portions of the shaft, sufficient friction may be created between the shaft and the connector to maintain a connection of the lid to the housing, while also allowing for disconnection of the lid from the housing.

A portion of the connector that at least partially encloses the one or more portions of the shaft may comprise a thickness. The thickness may be is selected based on a diameter of the shaft.

The connector may comprise one or more recesses. The one or more recesses may be configured to receive the one or more portions of the shaft. The one or more recesses may be configured to be open, e.g. to an exterior of the at least one other of the lid and housing. By configuring the one or more recesses to be open to the exterior of the housing, connection or disconnection of the lid to or from the housing may be allowed and/or facilitated. This may also reduce or prevent damage to the shaft, when the lid is being connected to or disconnected from the housing.

A diameter of the one or more recesses may be configured to be smaller than a diameter of the shaft.

By configuring the one or more recesses to comprise a diameter that is smaller than the diameter of the shaft, the interference or press fit may be formed between the connector and the shaft. This may in turn result in the force applied on the shaft and/or the increased friction between the connector and the shaft.

For example, when the housing comprises the connector, the connector may be formed to be integral with a seal of the assembly. This may facilitate the manufacture of the assembly, as the connector may be formed simultaneously with the seal. This may avoid the manufacture of an additional separate part. The seal may be arranged or arrangeable between the housing and the utility meter.

According to a second aspect of the present disclosure, there is provided a cover assembly for a utility meter. The assembly comprises a housing. The assembly comprises a lid. The lid is detachably connectable to the housing. At least one of the housing and the lid comprises a shaft. At least one other of the housing and the lid comprises a connector. The connector is configured to be connected to the shaft. When the lid is connected to the housing, the connector is configured to apply a force on the shaft that allows rotational movement of the lid relative to the housing and inhibits gravitational movement of the lid relative to the housing. The cover assembly may comprise any of the features of the cover assembly according to the first aspect.

According to a third aspect of the present disclosure, there is provided a utility meter comprising a cover assembly according to the first or second aspect. The utility meter may comprise a water meter or a thermal energy meter, such as a heat meter or a cooling meter. Alternatively, the utility meter may comprise a gas meter or an electricity meter.

According to fourth aspect of the present disclosure, there is provided a method of manufacturing a cover assembly for a utility meter. The method comprises forming a housing. The method comprises forming a lid. The lid is detachably connectable to the housing. The method comprises forming a connector. At least one of the housing and the lid comprises a shaft. At least one other of the housing and the lid comprises the connector. When the lid is connected to the housing, the connector is configured to connect to the shaft. When the lid is connected to the housing, the connector is configured to apply a force on the shaft that allows rotational movement of the lid relative to the housing and inhibits gravitational movement of the lid relative to the housing.

According to fifth aspect of the present disclosure, there is provided a computer program comprising computer executable instructions that, when executed by a processor, cause the processor to control an additive manufacturing apparatus to manufacture a cover assembly according to the first or second aspect or at least a part of the cover assembly according to the first or second aspect.

According to sixth aspect of the present disclosure, there is provided a method of manufacturing a device via additive manufacturing. The method comprises obtaining an electronic file representing a geometry of a product. The product is or comprises a cover assembly according to the first or second aspect or at least a part of the cover assembly according to the first or second aspect. The method comprises controlling an additive manufacturing apparatus to manufacture, over one or more additive manufacturing steps, the product according to the geometry specified in the electronic file.

The above summary is intended to be merely exemplary and non-limiting. The disclosure includes one or more corresponding aspects, embodiments or features in isolation or in various combinations whether or not specifically stated (including claimed) in that combination or in isolation. It should be understood that features defined above in accordance with any aspect of the present disclosure or below relating to any specific embodiment of the disclosure may be utilized, either alone or in combination with any other defined feature, in any other aspect or embodiment or to form a further aspect or embodiment of the disclosure.

### BRIEF DESCRIPTION OF THE DRAWINGS

These and other aspects of the present disclosure will now be described, by way of example only, with reference to the accompanying drawings, wherein:
- Figure 1: depicts a schematic side view of an exemplary utility meter comprising a cover assembly according to an embodiment of the disclosure;
- Figure 2: depicts a part-cutaway side view of the assembly of Figure 1 with a lid in an open position;
- Figure 3: depicts a perspective view of the assembly shown in Figure 1;
- Figure 4: depicts another perspective view of the assembly shown in Figure 1;
- Figure 5: depicts another part-cutaway side view of the assembly shown in Figure 1;
- Figure 6: depicts a perspective view of a first end portion of a shaft and a part of a connector of the assembly shown in Figure 1;
- Figure 7: depicts another perspective view of the assembly of Figure 1 with the lid in the open position; and
- Figure 8: depicts a flow chart showing in overview a method of manufacturing a cover assembly for a utility meter.

### DETAILED DESCRIPTION OF THE DRAWINGS

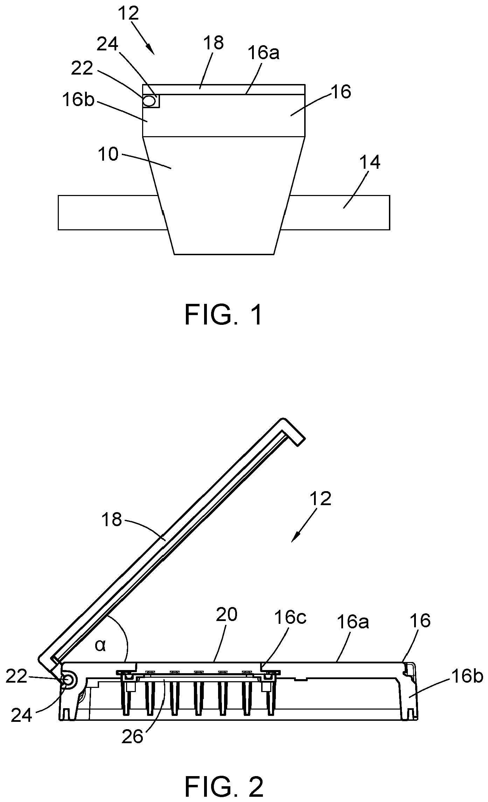

Figure 1 shows a schematic side view of an exemplary utility meter 10 comprising an assembly 12, such as a cover assembly. In the embodiment shown in Figure 1, the meter 10 is provided in the form of a water meter. The meter 10 may be configured to determine an amount of water that flows through a pipe 14. This amount may be an accumulative value, which may also be referred to as a consumed value. It will be appreciated that in other embodiments, the utility meter may be differently implemented, e.g. as a thermal energy meter, such as a heat meter or a cooling meter, gas meter, electricity meter or the like.

The assembly 12 may be connected to the meter 10, e.g. to protect the meter 10 from damage. The assembly 12 comprises a housing 16. The housing 16 may be configured to be attached to the meter 10. The housing 16 is configured to enclose at least a part of the meter 10. The housing 16 comprises an inspection portion 16a and a base portion 16b. The base portion 16b may be connected to inspection portion 16a. In this embodiment, the base portion 16b comprises four walls, which are arranged in a rectangular arrangement. However, it will be appreciated that in other embodiments, the base portion may be differently arranged and/or may comprise more or less than four walls.

The assembly 12 comprises a lid 18 that is detachably connectable to the housing 16. In the embodiment shown in Figure 1, the lid is connected to the housing 16. For example, the lid 18 may be connected to one of the walls of the base portion 16b. The lid 18 may also be referred to as a hinged lid.

When the lid 18 is connected to the housing 16, the lid 18 may be rotatable between a closed position and an open position. In the closed position, the lid 18 may be configured to cover at least partially the inspection portion 16a of the housing 16. In the embodiment shown in Figure 1, the lid 18 is configured to fully cover the inspection portion 16a of the housing 16. For example, in the closed position, the lid 18 may abut the inspection portion 16a of the housing 16.

Figure 2 shows a part-cutaway side view of the assembly 12 shown in Figure 1 with the lid 18 in the open position. In the embodiment shown in Figure 2, the lid 18 connected to housing 16 and in the open position. In the open position, the inspection portion 16a of the housing 16 may be uncovered. In the open position, an angle α between the lid 18 and the housing 16 may be larger than 0° and smaller than about 280°. For example, when the lid 18 is rotated between the closed and open positions, the angle α between the lid 18 and the housing 16 may be varied between about 0° and 270°.

The housing 16 comprises a transparent window 20 through which the amount of water that has flowed through the meter 10 can be inspected. For example, the meter 10 may comprise a display (not shown) for displaying the consumed value, e.g. the amount of water that has flowed through the meter. The display may be implemented as a liquid crystal display. For example, when the lid 18 is in the open position, the window 20 may be uncovered. When the lid 18 is in the closed position, at least the window 20 may be covered by the lid 18.

The inspection portion 16a may comprise a recess 16c. The window 20 may be arranged in the recess 16c. The housing may comprise a seal 26. The seal 26 is configured to extend around a periphery of the window 20 and the recess 16c. The seal 26 may be provided to prevent fluid and/or contamination from entering the housing 16, e.g. between the window 20 and the recess 16c. Additionally or alternatively, when the assembly 12 is being connected to the meter 10, the seal 26 may be configured to facilitate alignment of the housing 16 relative to the meter 10, e.g. such that the window 20 is aligned relative to the display of the meter 10. The seal 26 may be arranged such that the seal is arranged between the inspection portion 16a and the meter 10, when the assembly 12 is connected to the meter 10. For example, the seal 26 may be arranged on an underside of the inspection portion 16a. The seal 26 may be connected to the inspection portion 16a, e.g. to secure the window 20 in the recess 16c of the inspection portion 16a. The seal 26 may be directly formed in the housing 16, e.g. using an injection moulding process.

In the embodiment shown in Figure 2, the lid 18 comprises a shaft 22. The shaft 22 may be integral with the lid 18. For example, the lid 18 and the shaft 22 may be formed as a single component or part. It will be appreciated that in other embodiments, the shaft may be part of the housing and/or separately formed from the lid. The shaft 22 may define a pivot axis or an axis of rotation of the lid 18 relative to the housing 16.

The housing 16 may comprise a connector 24. The connector 24 may be part of the housing 16. It will be appreciated that in other embodiments, the connector may be part of the lid. The connector 24 may also be referred to as a guide for the shaft 22. The connector 24 is configured to connect to the shaft 22 and to apply a force on the shaft 22 that allows rotational movement of the lid 18 relative to the housing 16 and inhibits gravitational movement of the lid 18 relative to the housing 18. Gravitational movement of the lid 18 may be understood as rotational movement of the lid 18 relative to the housing 16 due to a gravitational force acting on the lid 18. For example, the connector 24 may be configured to apply the force on the shaft 22 such that the lid can be rotated between the closed and open positions and a resulting position of the lid 18 relative to the housing 16 is maintained. As such, the shaft 22 and the connector 24 may be considered as defining a self-locking hinge assembly.

The force applied on the shaft 22 may be considered as a compressive force. For example, the connector 24 is configured to form an interference fit or press fit with the shaft 22. The force applied on the shaft 22 may result in friction, e.g. increased friction, between the shaft 22 and the connector 24, when the lid is rotated relative to the housing 16. Due to the friction between the shaft 22 and the connector 24, gravitational movement of the lid 18 relative to the housing 18 may be inhibited. Expressed differently, the shaft 22 and the connector 24 may be considered to be self-locking due to the friction between the shaft 22 and the connector 24.

By configuring the connector to apply the force on the shaft 22 that allows rotational movement of the lid 18 relative to the housing 16 and inhibits gravitational movement of the lid 18 relative to the housing 18, reading of the meter 10, which may be vertically or horizontally installed, may be facilitated. Additionally or alternatively, this configuration of the connector 24 may avoid the use of additional fastenings, such as hooks, snap-hooks, clasps, clips or the like, to maintain the lid in an open or closed position, and/or may reduce a risk of damage to the connector and/or shaft.

The connector 24 may be formed from a first material. The shaft 22 may be formed from a second material. The first and second materials may selected such that the connector 24 applies the force on the shaft 22. For example, the first material may comprise an elastic modulus that is different from an elastic modulus of the second material. In this embodiment, the first material comprises an elastic modulus that is lower than an elastic modulus of the second material. This may result in an increased friction between the shaft 22 and the connector 24. For example, the first material comprises an elastomeric material, a thermoplastic elastomeric material (TPE), a thermoplastic vulcanizate (TPV), a polymer material and/or the like. An exemplary thermoplastic elastomeric material may be formed from block copolymers groups and may include, for example THERMOLASTOK or the like. The elastomeric material may comprise ethylene propylene diene monomer (EPDM) rubber or the like. An exemplary thermoplastic vulcanizate (TPV) material may comprise a polymer material, such as Polyphenylene sulfide (PPS), or a polyamide material, such as Polyphthalamide (PPA), or the like.

In this embodiment, the second material comprises a thermoplastic polymer material, such as a polycarbonate material or the like. For example, the polycarbonate material may comprise Makrolon ^{®} or the like. It will be appreciated that the first and second materials are not limited to the exemplary material disclosed herein and that in other embodiments other materials than those described herein may be used.

By forming the connector 24 from the first material and the shaft 22 from the second material, as described above, noise and/or squeaking, when the lid 18 is rotated relative to the housing 16, may be reduced or prevented.

The window 20 may be formed from a third material. The third material may comprise a thermoplastic polymer material, such as a polycarbonate material or the like. For example, the polycarbonate material may comprise Lexan^{®}243R.

In this embodiment, the seal 26 is formed from the same material as the connector 24, e.g. the first material. The seal 26 and the connector 24 may be integrally formed. Expressed differently, the seal 26 and the connector 24 may be formed as a single part or component. This may facilitate the manufacture of the assembly 12, as the connector 24 may be formed simultaneously with the seal 26. This may avoid the manufacture of an additional separate part. However, it will be appreciated that in other embodiments, the connector may be separately formed from the seal and/or from a different material than the seal.

The base portion 16b may comprise a recess 16d. The recess 16d may be arranged in one of the walls of the base portion 16b. The recess 16d may be arranged in proximity to the inspection portion 16a. The recess 16d may be centrally arranged in the wall of the base portion 16b. The connector 24 may be arranged in the recess 16d. For example, the connector 24 may be configured to extend from the interior of the base portion 16b to an outer surface of the base portion 16a.

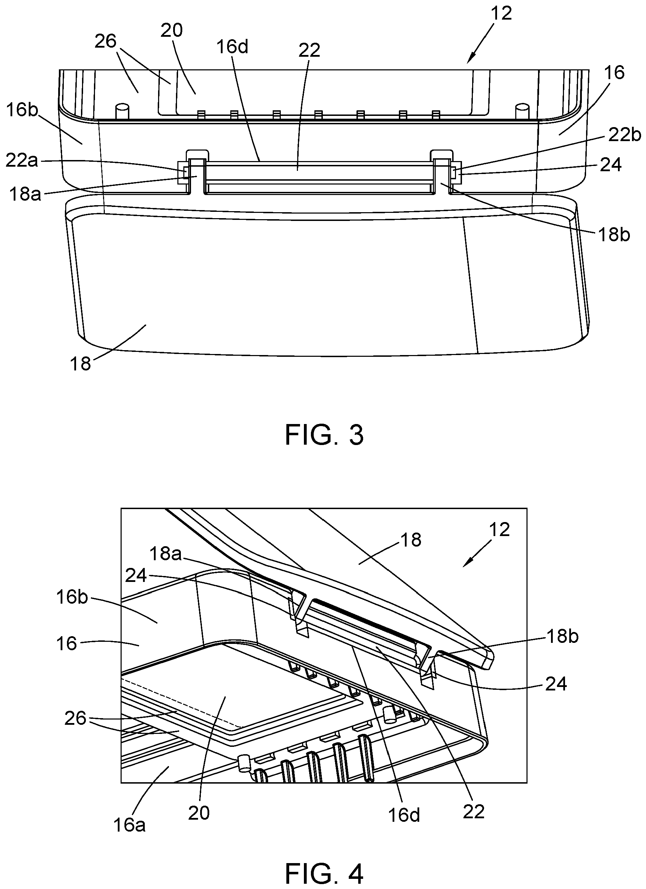

Figures 3 and 4 show perspective views of the assembly 12 shown in Figure 1. The shaft 22 may comprise a first end portion 22a and a second end portion 22b.

The connector 24 may be configured to connect to each of the first and second end portions 22a, 22b of the shaft 22. The connector 24 may also be configured to apply the force on each of the first and second end portions 22a, 22b of the shaft 22. It will be appreciated that in other embodiments, the connector may be configured to connect to one or more other portions of the shaft. For example, in such other embodiments, the connector may be configured to connect to a portion of the shaft that is located between the first and second end portions of the shaft.

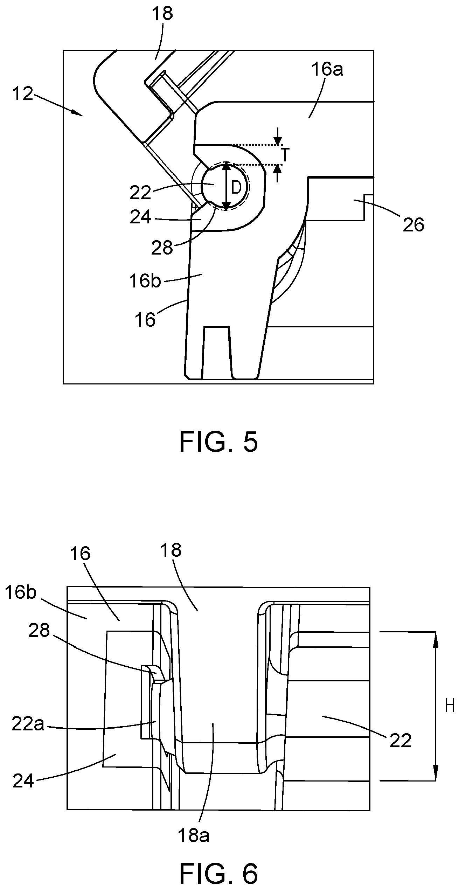

In the embodiment shown in Figures 5 and 6, the shaft 22 is provides as a single shaft that extends in the recess 16d of the base portion 16b, when the lid 18 is connected to the housing 16. However, it will be appreciated that in other embodiments, the shaft may be provided in the form of a first shaft and a second shaft, which may be coaxially arranged. In such embodiments, the first and second shafts may be arranged and/or configured in the same or similar manner as the first and second end portions of the shaft described herein.

As can be seen in Figures 3 and 4, the lid 18 is connected to the shaft 22, e.g. in proximity to the first and second end portions 22a, 22b of the shaft 22. The lid 18 may comprise a first connection portion 18a and a second connection portion 18b. The first and second portions 18a, 18b are configured to connect the lid 18 to the shaft 22. The first and second connections portions 18a, 18b are arranged to extend or protrude from the lid 18 in a perpendicular, .e.g. substantially perpendicular direction. The recess 16d of the base portion 16b is configured to accommodate the first and second connection portions 18a, 18b. This may facilitate rotational movement of the lid 18 between the open and closed positions and/or enable the lid 18 to be rotated relative to the housing such that angle α between the lid 18 and the housing varies between 0° and 270°.

Figure 5 shows another part-cutaway side view of the assembly 12 shown in Figure 1. Figure 6 shows a perspective view of the first end portion 22a of the shaft 22 and a part of the connector 24 of the assembly 12 shown in Figure 1. Only the first end portion 22a of the shaft 22 is shown in Figures 5 and 6. However, it will be appreciated that any of the features described in relation to the first end portion may also apply to the second end portion 22b of the shaft 22.

As can be best seen from Figure 5, when the lid 18 is connected to housing 16, the connector 24 is configured to at least partially enclose the first end portion 22a of the shaft 22. The connector 24 may be configured to enclose between about 70% and 80% of a circumference of the first end portion 22a of the shaft 22. In this embodiment, the connector 24 is configured to enclose about 75% of the circumference of the first end portion 22a of the shaft 22. By configuring the connector 24 to enclose between about 70% and 80% of a circumference of the first end portion 22a of the shaft 22, the force applied on the first end portion 22a of the shaft 22 may be sufficient to inhibit gravitational movement of the lid 18 relative to the housing 16. Additionally or alternatively, by configuring the connector 24 to enclose between about 70% and 80% of the circumference of the first end portion 22a of shaft 22, sufficient friction may be created between the shaft 22 and the connector 24 to maintain a connection of the lid 18 to the housing 16, while also allowing for disconnection of the lid 18 from the housing 16. Additionally or alternatively, this may reduce the risk of the lid 18 accidently becoming disconnected from the housing 16.

In this embodiment, the shaft 22 comprises a circular cross section. However, it will be appreciated that in other embodiments, the cross section of the shaft may have a different shape. For example, in such other embodiments, the shaft may comprise a polygonal cross section, such as a square cross section or a hexagonal cross section, or the like. A shaft comprising a polygonal cross section may facilitate and/or allow self-locking of the lid relative to the housing at one or more angles between the lid and the housing, which may be determined by the polygonal cross section of the shaft.

The connector 24 comprises a first recess 28 and a second recess. Only the first recess 28 is shown in Figures 5 and 6. However, it will be appreciated that any of the features described in relation to the first recess may also apply to the second recess. It will also be appreciated that in other embodiments, the connector may comprise more or less than two recesses.

The first recess 28 may be configured to receive the first end portion 22a of the shaft 28. As can be seen in Figures 5 and 6, when the lid 18 is connected to the housing 16, the first end portion 22a of the shaft 22 is positioned in the first recess 28. The first recess 28 is configured to be open to an exterior of the housing 18. For example, the first recess 28 may be implemented in the form of a slot, groove or the like. A dimension and/or shape of the first recess 28 may be selected so that the connector 24 encloses the end portion 22a of the shaft 22, as described above. By configuring the first recess 28 to be open to the exterior of the housing 16, connection or disconnection of the lid 18 to or from the housing 16 may be allowed and/or facilitated. This may also reduce or prevent damage to the shaft 22, when the lid 18 is being connected to or disconnected from the housing 16.

A cross section of the first recess 28 may be in part circular or substantially circular. The first recess 28 may be configured to comprise a diameter that is smaller than a diameter D of the shaft 22. For example, the first recess 28 may be configured such that the diameter of the first recess 28 is between about 0.2 mm and 0.3mm smaller than the diameter D of the shaft 22. This difference between the diameter of the first recess 28 and the shaft 22 may also be referred to as an allowance, which in turn may be understood as an amount of interference. In this embodiment, the diameter of the first recess 28 is about 2 mm and the diameter D of the shaft 22 is about 2.2 mm. The diameter of the first recess 28 may also be understood as a distance spanning across the first recess 28. It will be appreciated that the first recess and/or shaft are not limited to the exemplary dimensions and/or shapes disclosed herein.

By configuring the first recess 28 to comprise a diameter that is smaller than the diameter of the shaft 22, an interference or press fit may be formed between the connector 24 and the shaft 22, which may cause the force applied on the shaft and/or the increased friction between the connector and the shaft.

As described above, the connector 24 may be configured to enclose the first end portion 22a of the shaft 22. A portion of the connector 24 that encloses the first end portion 22a of the shaft 22 may comprise a thickness T, which is indicated in Figure 5. Expressed differently, the thickness T may correspond to a thickness of the first material that encloses the first end portion 22a of the shaft 22, as described above. The thickness T may be selected based on the diameter D of the shaft 22. For example, the thickness T may be a proportion of the diameter of the shaft 22. In this embodiment, the thickness T may be about of 50% of the diameter of the shaft 22. For example, the thickness T may be about 1 mm. However, it will be appreciated that the thickness may depend on one or more conditions and/or requirements of a method of manufacturing the assembly. As such, it will be appreciated that in other embodiments, the thickness may be more or less than 50% of the diameter of the shaft 22.

A height H of the recess 16d in the base portion 16b may depend on the diameter D of the shaft 22 and the thickness T of the portion of the connector 24 that encloses the first end portion 22a of the shaft 22. For example, the height H of the recess 16 may correspond, e.g. substantially correspond, to the sum of the diameter D of the shaft 22 plus two times the thickness T. In this embodiment, the height of the recess 16d may be about 4 mm. However, it will be appreciated that in other embodiments, the height of the recess may be larger or smaller than 4 mm. The term "height" may be understood as an extension or dimension of the recess 16d in a direction perpendicular, e.g. substantially perpendicular, to the shaft 22, e.g. the pivot axis or axis of rotation of the lid 18 relative to the housing 16.

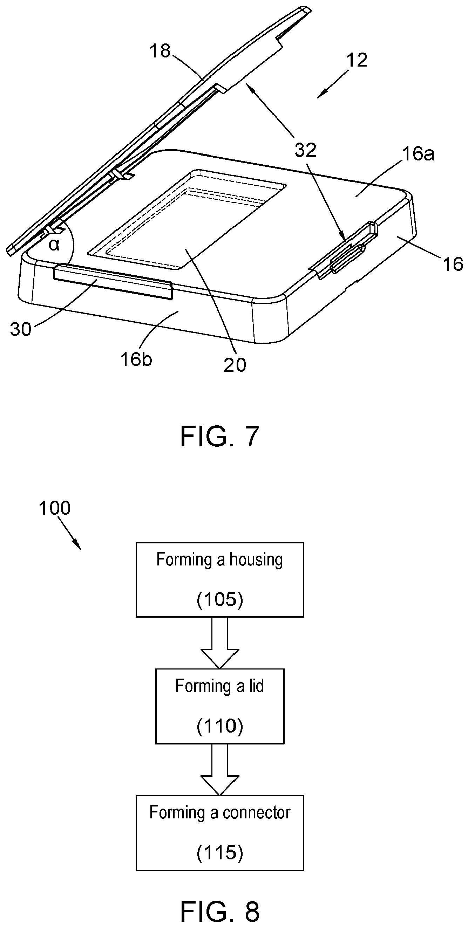

Figure 7 shows another perspective view of the assembly 12 with the lid in the open position. In the embodiment shown, the angle α between the lid 18 and the housing 16 is less than 90°. As described above, the force applied by the connector 24 on the shaft 22 inhibits gravitational movement of the lid 18, e.g. into the closed position of the lid 18. As such, the shaft 22 and the connector 24 may be considered as defining a self-locking hinge assembly.

In this embodiment, the assembly 12 comprises an indicator 30. The indicator can be used to indicate a type of the utility meter. For example, a colour of the indicator may be indicative of the utility meter being a warm-water or a cold-water utility meter.

The assembly also includes a closure mechanism 32, which in this embodiment is implemented in the form of a hook and bar mechanism. When the lid 18 is in the closed position, the closure mechanism 32 may be configured to maintain the lid 18 in the closed position, e.g. by releasably fastening the lid 18 to the housing 16.

Figure 8 is a flow chart showing in overview a method 100 of manufacturing a cover assembly for a utility meter. The assembly may comprise any of the feature of the assembly 12 described above.

In step 105, the method 100 comprises forming a housing.

In step 110, the method comprises forming a lid. The lid may be detachably connectable to the housing.

In step 115, the method comprises forming a connector.

The housing, the lid and/or the connector may be formed using an injection moulding process. For example, the housing, the lid and the shaft may be formed from the second material described above. The connector may be formed from the first material described above. The connector may be formed to be integral with a seal of the assembly, as described above. In such embodiments, the connector and the seal may be simultaneously formed. However, it will be appreciated that in other embodiments, the connector may be formed separately from the seal.

The method may also comprise forming a transparent window. The window may be formed from the third material described above.

The method may comprise arranging or forming the connector in the housing or the lid. The method may comprising arranging or forming the window and/or the seal in the housing. For example, when the connector is part of the housing, the connector and the seal may be directly formed in the housing, e.g. using the injection moulding process. In embodiments, where the connector is formed separately from the seal, the connector may be arranged between at least two portions of the housing, e.g. the base portion and the inspection portion of the housing. The two portions of the housing may be connected or welded to each other, e.g. such that the connector is secured or fastened between the two portions of the housing and/or such that non-destructive opening of the housing, e.g. the two portions of the housing, is not possible. This may secure the assembly and/or the utility meter against any unwanted external tampering.

It will be appreciated that steps 105-115 of the method 100 may be performed in any order. Additionally or alternatively, any of steps 105-115 may be sequentially or simultaneously performed.

It will be appreciated that in some embodiments, the method 100 may comprise using an additive manufacturing process. A common example of additive manufacturing is 3D printing. However, other methods of additive manufacturing are available. Rapid prototyping or rapid manufacturing are also terms, which may be used to describe additive manufacturing processes.

As used herein, "additive manufacturing" refers generally to manufacturing processes wherein successive layers of material(s) are provided on each other to "buildup" layer-by-layer or "additively fabricate", a three-dimensional component. This is compared to some subtractive manufacturing methods (such as milling or drilling), wherein material is successively removed to fabricate the part. The successive layers generally fuse together to form a monolithic component which may have a variety of integral sub-components.

Suitable additive manufacturing techniques in accordance with the present disclosure include, for example, Fused Deposition Modeling (FDM), 3D printing such as by inkjets and laserjets, Sterolithography (SLA), Digital Light Processing (DLP), Continuous Digital Light Processing (CDLP), Material Jetting (MJ), NanoParticle Jetting (NPJ), Drop On Demand (DOD), Binder Jetting (BJ), Multi Jet Fusion (MJF), Laminated Object Manufacturing (LOM) and other known processes.

The additive manufacturing processes described herein may be used for forming components using any suitable material. For example, the material may be plastic, composite, polymer, copolymer, epoxy, photopolymer resin, or any other suitable material that may be in solid, liquid, powder, sheet material or any other suitable form or combinations thereof. These materials are examples of materials suitable for use in additive manufacturing processes, which may be suitable for the fabrication of examples described herein.

The additive manufacturing process disclosed herein allows a single component or part of the assembly to be formed from multiple materials. Thus, the examples described herein may be formed from any suitable mixtures of the above materials. For example, a component or part may include multiple layers, segments, or parts that are formed using different materials, processes, and/or on different additive manufacturing machines. In this manner, components or parts may be constructed, which have different materials and material properties for meeting the demands of any particular application. In addition, although the components or parts described herein are constructed entirely by additive manufacturing processes, it should be appreciated that in alternate embodiments, all or a portion of these components or parts may be formed via casting, machining, moulding, e.g. injection moulding, and/or any other suitable manufacturing process. Indeed, any suitable combination of materials and manufacturing methods may be used to form these components or parts.

Additive manufacturing processes typically fabricate components or parts based on three-dimensional (3D) information, for example a three-dimensional computer model (or design file), of the component.

Accordingly, examples described herein not only include a product or components as described herein, but also methods of manufacturing such a product or components via additive manufacturing and computer software, firmware or hardware for controlling the manufacture of such a product via additive manufacturing. It will be appreciated that the product may comprise the assembly as described herein.

The structure of one or more parts of the product may be represented digitally in the form of a design file. A design file, or computer aided design (CAD) file, is a configuration file that encodes one or more of the surface or volumetric configuration of the shape of the product. That is, a design file represents the geometrical arrangement or shape of the product.

Design files can take any now known or later developed file format. For example, design files may be in the Stereolithography or "Standard Tessellation Language" (.stl) format which was created for stereolithography CAD programs of 3D Systems, or the Additive Manufacturing File (.amf) format, which is an American Society of Mechanical Engineers (ASME) standard that is an extensible markup-language (XML) based format designed to allow any CAD software to describe the shape and composition of any three-dimensional object to be fabricated on any additive manufacturing printer.

Further examples of design file formats include AutoCAD (.dwg) files, Blender (.blend) files, Parasolid (.x_t) files, 3D Manufacturing Format (.3mf) files, Autodesk (3ds) files, Collada (.dae) files and Wavefront (.obj) files, although many other file formats exist.

Design files can be produced using modelling (e.g. CAD modelling) software and/or through scanning the surface of a product to measure the surface configuration of the product.

Once obtained, a design file may be converted into a set of computer executable instructions that, once executed by a processor, cause the processor to control an additive manufacturing apparatus to produce the product according to the geometrical arrangement specified in the design file. The conversion may convert the design file into slices or layers that are to be formed sequentially by the additive manufacturing apparatus. The instructions (otherwise known as geometric code or "G-code") may be calibrated to the specific additive manufacturing apparatus and may specify the precise location and amount of material that is to be formed at each stage in the manufacturing process. As discussed above, the formation may be through deposition, through sintering, or through any other form of additive manufacturing method.

The code or instructions may be translated between different formats, converted into a set of data signals and transmitted, received as a set of data signals and converted to code, stored, etc., as necessary. The instructions may be an input to the additive manufacturing system and may come from a part designer, an intellectual property (IP) provider, a design company, the operator or owner of the additive manufacturing system, or from other sources. An additive manufacturing system may execute the instructions to fabricate the product using any of the technologies or methods disclosed herein.

Design files or computer executable instructions may be stored in a (transitory or non-transitory) computer readable storage medium (e.g., memory, storage system, etc.) storing code, or computer readable instructions, representative of the product to be produced. As noted, the code or computer readable instructions defining the product that can be used to physically generate the object, upon execution of the code or instructions by an additive manufacturing system. For example, the instructions may include a precisely defined 3D model of the product and can be generated from any of a large variety of well-known computer aided design (CAD) software systems such as AutoCAD^{®}, TurboCAD^{®}, DesignCAD 3D Max, etc. Alternatively, a model or prototype of the component may be scanned to determine the three-dimensional information of the component.

Accordingly, by controlling an additive manufacturing apparatus according to the computer executable instructions, the additive manufacturing apparatus can be instructed to print out one or more parts of the product. These can be printed either in assembled or unassembled form. For instance, different sections of the product may be printed separately (as a kit of unassembled parts) and then subsequently assembled. Alternatively, the different parts may be printed in assembled form.

In light of the above, embodiments include methods of manufacture via additive manufacturing. This includes the steps of obtaining an electronic file or design file representing a geometry of the product and controlling an additive manufacturing apparatus to manufacture the product, over one or more additive manufacturing steps, the product according to the geometry specified in the electronic file or design file. The additive manufacturing apparatus may include a processor that is configured to automatically convert the electronic file or design file into computer executable instructions for controlling the manufacture of the product. In these embodiments, the electronic file or design file itself can automatically cause the production of the product once input into the additive manufacturing device. Accordingly, in this embodiment, the electronic file or design file itself may be considered computer executable instructions that cause the additive manufacturing apparatus to manufacture the product. Alternatively, the electronic file or design file may be converted into instructions by an external computing system, with the resulting computer executable instructions being provided to the additive manufacturing device.

Given the above, the design and manufacture of implementations of the subject matter and the operations described in this specification can be realized using digital electronic circuitry, or in computer software, firmware, or hardware, including the structures disclosed in this specification and their structural equivalents, or in combinations of one or more of them. For instance, hardware may include processors, microprocessors, electronic circuitry, electronic components, integrated circuits, etc. Implementations of the subject matter described in this specification can be realized using one or more computer programs, i.e., one or more modules of computer program instructions, encoded on computer storage medium for execution by, or to control the operation of, data processing apparatus. Alternatively or in addition, the program instructions can be encoded on an artificially-generated propagated signal, e.g., a machine-generated electrical, optical, or electromagnetic signal that is generated to encode information for transmission to suitable receiver apparatus for execution by a data processing apparatus. A computer storage medium can be, or be included in, a computer-readable storage device, a computer-readable storage substrate, a random or serial access memory array or device, or a combination of one or more of them. Moreover, while a computer storage medium is not a propagated signal, a computer storage medium can be a source or destination of computer program instructions encoded in an artificially-generated propagated signal. The computer storage medium can also be, or be included in, one or more separate physical components or media (e.g., multiple CDs, disks, or other storage devices).

Although additive manufacturing technology is described herein as enabling fabrication of complex objects by building objects point-by-point, layer-by-layer, typically in a vertical direction, other methods of fabrication are possible and within the scope of the present subject matter. For example, although the discussion herein refers to the addition of material to form successive layers, one skilled in the art will appreciate that the methods and structures disclosed herein may be practiced with any additive manufacturing technique or other manufacturing technology.

Although the disclosure has been described in terms of particular embodiments as set forth above, it should be understood that these embodiments are illustrative only and that the claims are not limited to those embodiments. Those skilled in the art will be able to make modifications and alternatives in view of the disclosure, which are contemplated as falling within the scope of the appended claims. Each feature disclosed or illustrated in the present specification may be incorporated in any embodiments, whether alone or in any appropriate combination with any other feature disclosed or illustrated herein.

### LIST OF REFERENCE NUMERALS

- 10: utility meter
- 12: cover assembly
- 14: pipe
- 16: housing
- 16a: inspection portion
- 16b: base portion
- 16c: recess of inspection portion
- 16d: recess of base portion
- 18: lid
- 18a: first connection portion
- 18b: second connection portion
- 20: window
- 22: shaft
- 22a: first end portion
- 22b: second end portion
- 24: connector
- 26: seal
- 28: first recess of connector
- 30: indicator
- 32: closure mechanism
- 100: method
- 105-115: method steps

## Claims

1. A cover assembly (12) for a utility meter (10) comprising:
a housing (16);
a lid (18) that is detachably connectable to the housing (16);
wherein at least one of the housing (16) and the lid (18) comprises a shaft (22) and at least one other of the housing (16) and the lid (18) comprises a connector (24), and
wherein when the lid (18) is connected to the housing (16), the connector (24) is configured to connect to the shaft (22) and to apply a force on the shaft (22) that allows rotational movement of the lid (18) relative to the housing (16) and inhibits gravitational movement of the lid (18) relative to the housing (16).

2. The assembly (12) of claim 1, wherein the housing (16) comprises a window (20) for displaying a consumed value and wherein when the lid (18) is connected to the housing (16), the lid (18) is rotatable between an open position, in which the window (20) is uncovered, and a closed position, in which at least the window (20) is covered by the lid.

3. The assembly (12) of claim 1 or 2, wherein the connector (24) is formed from a first material and the shaft (22) is formed from a second material, the first and second materials being selected such that the connector (24) applies the force on the shaft (22), when the lid (18) is connected to the housing (16).

4. The assembly (12) of claim 3, wherein the first material comprises an elastic modulus that is lower than an elastic modulus of the second material.

5. The assembly (12) of claims 3 or 4, wherein the first material comprises an elastomeric material or a thermoplastic elastomeric material and the second material comprises a thermoplastic polymer material.

6. The assembly (12) of any preceding claim, wherein when the lid (18) is connected to the housing (16), the connector (24) is configured to form an interference fit or press fit with one or more portions of the shaft (22).

7. The assembly (12) of any preceding claim, wherein when the lid (18) is connected to housing (16), the connector (24) is configured to at least partially enclose one or more portions of the shaft (22).

8. The assembly (12) of claim 7, wherein the connector (24) is configured to enclose between about 70% and 80% of a circumference of the one or more portions of the shaft (22).

9. The assembly (12) of any one of claims 6 to 8, wherein the connector (24) comprises one or more recesses (28) configured to receive the one or more portions of the shaft (22), the one or more recesses (28) being configured to be open to an exterior of the at least one other of the lid (18) and housing (16).

10. The assembly (12) of claim 9, wherein a diameter of the one or more recesses (28) is configured to be smaller than a diameter of the shaft (22).

11. The assembly (12) of any preceding claim, wherein when the housing (16) comprises the connector, the connector (24) is formed to be integral with a seal (26) of the assembly (12), the seal (26) being arrangeable between the housing (16) and the utility meter (10).

12. A utility meter (10) comprising a cover assembly (12) according to any one of claims 1 to 11.

13. The utility meter according to claim 12, wherein the utility meter comprises a water meter or a thermal energy meter, such as a heat meter or a cooling meter.

14. A method (100) of manufacturing a cover assembly (12) for a utility meter (10), the method comprising:
forming (105) a housing (16);
forming (110) a lid (18) that is detachably connectable to the housing;
forming (115) a connector;
wherein at one least one of the housing and the lid (18) comprises a shaft (22) and at least one other of the housing and the lid (18) comprises the connector, and
wherein when the lid (18) is connected to the housing, the connector (24) is configured to connect to the shaft and to apply a force on the shaft (22) that allows rotational movement of the lid (18) relative to the housing and inhibits gravitational movement of the lid (18) relative to the housing.

15. A computer program comprising computer executable instructions that, when executed by a processor, cause the processor to control an additive manufacturing apparatus to manufacture a cover assembly (12) of any one of claims 1 to 11.

16. A method of manufacturing a device via additive manufacturing, the method comprising:
obtaining an electronic file representing a geometry of a product, wherein the product is a cover assembly (12) of any one of claims 1 to 11; and
controlling an additive manufacturing apparatus to manufacture, over one or more additive manufacturing steps, the product according to the geometry specified in the electronic file.
